# EUROPÄISCHE PATENTANMELDUNG

(11) **EP 4 380 328 A1**
(43) Veröffentlichungstag der Anmeldung: **05.06.2024**
(21) Anmeldenummer: 23207593.7
(22) Anmeldetag: 03.11.2023
(51) Int. Cl.: H05K 7/14, H05K 1/14

(54) **FELDGERÄT DER AUTOMATISIERUNGSTECHNIK**

(30) Priorität: 29.11.2022 DE 102022131613
(71) Anmelder: Endress+Hauser SE+Co. KG, 79689 Maulburg (DE)
(72) Erfinder: Di Cosola, Vitogiuseppe, 79258 Hartheim (DE); Schonhardt, Raphael, 79618 Rheinfelden (DE); Strittmatter, Christian, 79736 Rickenbach (DE); Gerwig, Simon, 79650 Schopfheim (DE); Lais, Michael, 79677 Schönau im Schwarzwald (DE)
(74) Vertreter: Laufer, Michael

(57) **Zusammenfassung**

Feldgerät der Automatisierungstechnik (10), aufweisend:
- ein Feldgerätegehäuse (12);
- eine Feldgeräteelektronik (15) mit zumindest einer ersten Leiterplatte (15.1) und einer zweiten Leiterplatten (15.2), wobei die erste und die zweite Leiterplatte (15.1, 15.2) an einer ersten Leiterplattenkante (15.11) der zumindest ersten Leiterplatte (15.1) über eine erste Steck- und Gegensteckverbindung (15.4) elektrisch miteinander verbunden sind,
- wobei zumindest die erste Leiterplatte (15.1) an der zweiten Leiterplattenkante (15.12) eine derartige Außenkontur aufweist, dass die erste Leiterplatte seitlich zwei federarmähnliche Segmente (15.15) aufweist, die durch entsprechende Ausformungen der Außenkontur an den zu einer Seitenwandung des Feldgerätegehäuses gerichteten Leiterplattenkanten (15.13, 15.14) der ersten Leiterplatte ausgebildet sind, wobei die zumindest erste Leiterplatte (15.1) ferner derartig in das Feldgerätegehäuse (12) eingebracht ist, dass die federarmähnlichen Segmente (15.15) eine Spannung entlang der Längsachse (70) des Feldgerätegehäuses erzeugen, so dass die an der ersten Leiterplattenkante (15.11) der zumindest ersten Leiterplatte (15.1) angeordnete erste Steck- und Gegensteckverbindung (15.5) ineinander gepresst wird.

## Beschreibung

Die Erfindung bezieht sich auf ein Feldgerät der Automatisierungstechnik.

Aus dem Stand der Technik sind Feldgeräte bekannt, die in industriellen Anlagen zum Einsatz kommen. In der Prozessautomatisierungstechnik ebenso wie in der Fertigungsautomatisierungstechnik werden vielfach Feldgeräte eingesetzt. Als Feldgeräte werden im Prinzip alle Geräte bezeichnet, die prozessnah eingesetzt werden und prozessrelevante Informationen liefern oder verarbeiten. So werden Feldgeräte zur Erfassung und/oder Beeinflussung von Prozessgrößen verwendet. Zur Erfassung von Prozessgrößen dienen Messgeräte, bzw. Sensoren. Diese werden beispielsweise zur Druck- und Temperaturmessung, Leitfähigkeitsmessung, Durchflussmessung, etc. verwendet und erfassen die entsprechenden Prozessvariablen Druck, Temperatur, Leitfähigkeit, pH-Wert, Füllstand, Durchfluss etc. Zur Beeinflussung von Prozessgrößen werden Aktoren verwendet. Diese sind beispielsweise Pumpen oder Ventile, die den Durchfluss einer Flüssigkeit in einem Rohr oder den Füllstand in einem Behälter beeinflussen können. Neben den zuvor genannten Messgeräten und Aktoren werden unter Feldgeräten auch Remote I/Os, Funkadapter bzw. allgemein Geräte verstanden, die auf der Feldebene angeordnet sind.

Eine Vielzahl solcher Feldgeräte wird von der Endress+Hauser - Gruppe produziert und vertrieben.

Derartige Feldgeräte weisen ein, insbesondere zumindest zweitweise und/oder zumindest abschnittsweise mit einem Prozessmedium in Kontakt stehendes Sensorelement auf, welches der Erzeugung eines von der Prozessgröße abhängigen Signals dient. Ferner weisen diese Feldgeräte eine in einem Gehäuse angeordnete Elektronikeinheit auf, wobei die Elektronikeinheit der Verarbeitung und/oder Weiterleitung von der Sensoreinheit erzeugten Signalen, insbesondere elektrischen und/oder elektronischen Signalen, dient. Typischerweise umfasst die Elektronikeinheit mehrere Leiterplatten mit darauf angeordneten Bauteilen. Die Leiterplatten sind üblicherweise in einem Leiterplattenhalter angeordnet und mechanisch fixiert.

Nachteilig an einem derartigen Aufbau, bestehend aus mehreren Leiterplatten, ist, dass die notwendigen elektrischen Verbindungen, die üblicherweise über Steck- und Gegensteckverbindungen hergestellt werden, nicht dauerhaft bzw. nicht zuverlässig funktionieren. Grund hierfür ist, dass es aufgrund von Toleranzen zu Spiel in der Steck- und Gegensteckverbindungen kommen kann, so dass im schlimmsten Fall die Steck- und Gegensteckverbindungen getrennt wird.

Der Erfindung liegt die somit die Aufgabe zugrunde, ein Feldgerät der Automatisierungstechnik vorzuschlagen, bei dem die Leiterplatten über eine Steck- und Gegensteckverbindungen sicher elektrisch kontaktiert werden.

Die Aufgabe wird erfindungsgemäß gelöst durch das Feldgerät der Automatisierungstechnik gemäß Patentanspruch 1.

Das erfindungsgemäße Feldgerät der Automatisierungstechnik umfasst:
- ein Feldgerätegehäuse;
- eine in dem Feldgerätegehäuse angeordnete Feldgeräteelektronik mit zumindest einer ersten Leiterplatte, die vorzugsweise entlang einer Längsachse des Feldgerätegehäuse ausgerichtet bzw. orientiert ist und einer zweiten Leiterplatten, die vorzugsweise quer zu einer Längsachse des Feldgerätegehäuses ausgerichtet bzw. orientiert ist, wobei die erste und die zweite Leiterplatte an einer ersten Leiterplattenkante der zumindest ersten Leiterplatte über eine erste Steck- und Gegensteckverbindung elektrisch miteinander verbunden sind,
- wobei zumindest die erste Leiterplatte an der der ersten Leiterplattenkante gegenüberliegenden zweiten Leiterplattenkante eine derartige Außenkontur aufweist, dass die erste Leiterplatte seitlich zwei federarmähnliche Segmente aufweist, die durch entsprechende Ausformungen der Außenkontur an den zu einer Seitenwandung des Feldgerätegehäuses gerichteten Leiterplattenkanten der ersten Leiterplatte ausgebildet sind, wobei die zumindest erste Leiterplatte ferner derartig in das Feldgerätegehäuse eingebracht ist, dass die federarmähnlichen Segmente eine Spannung entlang der Längsachse des Feldgerätegehäuses erzeugen, so dass die an der ersten Leiterplattenkante der zumindest ersten Leiterplatte angeordnete erste Steck- und Gegensteckverbindung ineinander gepresst wird.

Eine vorteilhafte Ausgestaltung des erfindungsgemäßen Feldgerätes der Automatisierungstechnik kann vorsehen, dass die in dem Feldgerätegehäuse angeordnete Feldgeräteelektronik ferner eine weitere Leiterplatte umfasst, die vorzugsweise quer zu der Längsachse des Feldgerätegehäuses ausgerichtet bzw. orientiert ist, wobei die weitere und die erste Leiterplatte an der zweiten Leiterplattenkante der ersten Leiterplatte über eine zweite Steck- und Gegensteckverbindung elektrisch miteinander verbunden sind, wobei die weitere Leiterplatte mechanisch in dem Feldgerätegehäuse fixiert ist und wobei die weitere Leiterplatte für die federarmähnlichen Segmente der ersten Leiterplatte entsprechende Widerlager aufweist, wobei die Widerlage und die erste sowie die weitere Leiterplatte derartig zueinander angeordnet und/oder ausgebildet sind, dass im eingesteckten Zustand der zweiten Steck- und Gegensteckverbindung die federarmähnlichen Segmente der ersten Leiterplatte durch die Widerlager der weiteren Leiterplatte derartig abgestützt werden, dass die Spannung entlang der Längsachse des Feldgerätegehäuses erzeugt und somit die an der ersten Leiterplattenkante der zumindest ersten Leiterplatte angeordnete erste Steck- und Gegensteckverbindung ineinander gepresst wird. Insbesondere kann die Ausgestaltung des erfindungsgemäßen Feldgerätes der Automatisierungstechnik vorsehen, dass die federarmähnlichen Segmente an der zweiten Leiterplattenkante der ersten Leiterplatte jeweils zumindest eine hervorstehende Anschlagsfläche zum Abstützen an den Widerlagern der weiteren Leiterplatte aufweisen und/oder als Widerlager Teile einer Unterseite der weiteren Leiterplatte dienen.

Eine weitere vorteilhafte Ausgestaltung des erfindungsgemäßen Feldgerätes der Automatisierungstechnik kann vorsehen, dass das Feldgerät ferner einen in dem Feldgerätegehäuse angeordneten Leiterplattenhalter zur Halterung zumindest der weiteren Leiterplatte umfasst, wobei die weitere Leiterplatte durch den Leiterplattenhalter mechanisch in dem Feldgerätegehäuse fixiert ist, wobei der Leiterplattenhalter mit einer umlaufenden Außenkontur einer Wandung zumindest in einem Teilabschnitt an eine Innenkontur des Feldgerätegehäuses derartig angepasst ist, dass die Außenkontur des Leiterplattenhalters an der Innenkontur des Feldgerätegehäuses im Wesentlichen bündig anliegt, wobei der Leiterplattenhalter im Bereich des Teilabschnittes zumindest einen Einrastmechanismus zur Befestigung der ersten Leiterplatte und die erste Leiterplatte, insb. die federarmähnlichen Segmente der ersten Leiterplatte, zumindest einen zu dem Einrastmechanismus des Leiterplattenhalters entsprechenden

Gegeneinrastmechanismus aufweisen, wobei der Einrast- und Gegeneinrastmechanismus so aufeinander abgestimmt und ausgebildet ist, dass im eingerasteten Zustand ein Verrutschen, insb. ein Herausrutschen, der ersten Leiterplatte aus dem Leiterplattenhalter verhindert wird aber dennoch im eingerasteten Zustand eine axiale Bewegung der ersten Leiterplatte möglich ist, so dass, durch die erzeugte Spannung entlang der Längsachse des Feldgerätegehäuses, die erste Steck- und Gegensteckverbindung ineinander gepresst wird.

Eine weitere vorteilhafte Ausgestaltung des erfindungsgemäßen Feldgerätes der Automatisierungstechnik kann vorsehen, dass das Feldgerät ferner einen in dem Feldgerätegehäuse angeordneten Leiterplattenhalter zur Halterung zumindest der ersten und/oder der zweiten Leiterplatte umfasst, wobei der Leiterplattenhalter mit einer umlaufenden Außenkontur einer Wandung zumindest in einem Teilabschnitt an eine Innenkontur des Feldgerätegehäuses derartig angepasst ist, dass die Außenkontur des Leiterplattenhalters an der Innenkontur des Feldgerätegehäuses im Wesentlichen bündig anliegt, wobei der Leiterplattenhalter für die federarmähnlichen Segmente der ersten Leiterplatte entsprechende Widerlager umfasst, die derartig angeordnet und ausgebildet sind, dass die federarmähnlichen Segmente der ersten Leiterplatte in einem eingeführten Zustand, bei dem die erste Leiterplatte in den Leiterplattenhalter eingeführt ist, durch die Widerlager derartig abgestützt werden, dass die Spannung entlang der Längsachse des Feldgerätegehäuses erzeugt und somit die an der ersten Leiterplattenkante der zumindest ersten Leiterplatte angeordnete erste Steck- und Gegensteckverbindung ineinander gepresst wird. Insbesondere kann die Ausgestaltung vorsehen, dass die Widerlager in Form von Ausnehmungen, insb. Öffnungen, die in die Wandung des Leiterplattenhalters eingebracht sind, ausgeführt sind.

Eine weitere vorteilhafte Ausgestaltung des erfindungsgemäßen Feldgerätes der Automatisierungstechnik kann vorsehen, dass der Leiterplattenhalter eine becherähnliche Form aufweist.

Eine weitere vorteilhafte Ausgestaltung des erfindungsgemäßen Feldgerätes der Automatisierungstechnik kann vorsehen, dass die federarmähnlichen Segmente jeweils einen länglichen Steg aufweisen, der vorzugsweise eine Länge im Bereich von 5 - 20 mm und/oder vorzugsweise eine Breite im Bereich von 1,5 - 0,5 mm, vorzugsweise im Bereich von 0,8 - 1,2 mm aufweist.

Die Erfindung wird anhand der nachfolgenden Zeichnungen näher erläutert. Es zeigt:
Fig. 1: eine Schnittdarstellung durch ein erfindungsgemäßes Feldgerät der Automatisierungstechnik,
Fig. 2: eine Schnittdarstellung durch den Innenraum des Feldgerätegehäuses, und
Fig. 3: eine erfindungsgemäß ausgebildete Leiterplatte für eine sich in dem Innenraum befindliche Feldgeräteelektronik.

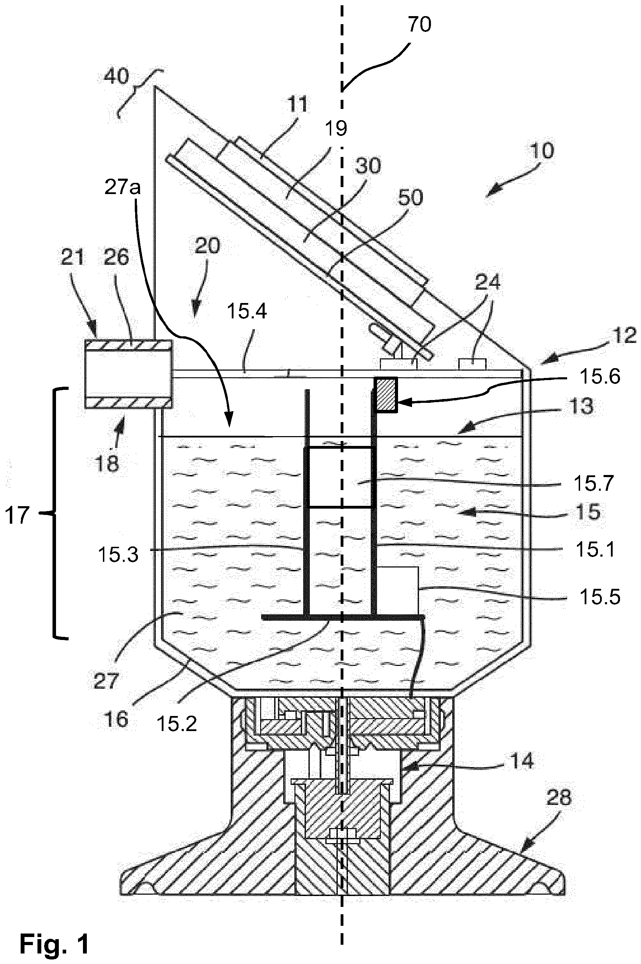

Fig. 1 zeigt exemplarisch eine Schnittdarstellung durch ein Feldgerät der Automatisierungstechnik. Das Feldgerät 10 umfasst ein Feldgerätegehäuse 12, das einen Innenraum 13 umschließt. Das Feldgerätegehäuse 12 weist einen zumindest abschnittsweise rotationssymmetrischen Bereich 17 auf, in den ein noch näher zu beschreibender Leiterplattenhalter 16 eingebracht sein kann.

Ferner umfasst das Feldgerät 10 ein endseitig an dem Feldgerätegehäuse 12 angeordnete Sensorbaugruppe mit einem Sensor- und/oder Aktorelement 14 zum Stellen und/oder Erfassen einer Prozessgröße und einen Prozessanschluss 28. Bei dem Prozessanschluss 28 kann es sich um eine Gewindebauform oder um einen schraub- oder klemmbaren Flansch handeln.

Das Sensor- und/oder Aktorelement 14 umfasst im vorliegenden Ausführungsbeispiel ein Füllstandsensorelement zum Erfassen eines Füllstandes als Prozessgröße. Gleichwohl ist die Erfindung nicht auf die Art bzw. konkrete Ausgestaltung des Sensor- und/oder Aktorelements als Füllstandsensorelement beschränkt, sondern kann prinzipiell auf jedes andere Sensor- oder Aktorprinzip übertragen werden.

Zum Bereitstellen und/oder Aufbereiten eines Sensor- und/oder Aktorsignals dient eine in einem Innenraum 13 des Feldgerätegehäuses eingebrachte Feldgeräteelektronik 15, die dazu ausgebildet ist, das Sensor- und/oder Aktorelement 14 zu betreiben.

In dem vorliegenden Ausführungsbeispiel weist die Feldgeräteelektronik eine erste Leiterplatte 15.1 und eine dritte Leiterplatte 15.3 auf, die jeweils entlang einer Längsachse des Feldgerätegehäuses 70 in dem Innenraum ausgerichtet sind sowie eine zweite Leiterplatte 15.2, die quer zu der Längsachse des Feldgerätegehäuses ausgerichtet bzw. orientiert ist, so dass die erste und dritte Leiterplatte 15.1, 15.3 in einem Winkel von 90° zu der zweiten Leiterplatte 15.2ausgerichtet sind bzw. orthogonal zueinanderstehen. Die erste und zweite Leiterplatte 15.1, 15.2 sind über eine erste, vorzugsweis starre Steck- und Gegensteckverbindung 15.5 elektrisch miteinander verbunden. Hierfür kann die erste Leiterplatte 15.1 an ihrer ersten Leiterplattenkante 15.11 einen, vorzugsweisen starren Steckverbinder und die zweite Leiterplatte 15.2 einen dazu entsprechenden, vorzugsweise ebenfalls starren Gegensteckverbinder aufweisen, die derartig ausgebildet und aufeinander abgestimmt sind, dass diese ineinander steckbar sind.

Die Feldgeräteelektronik 15 umfasst ferner eine als eine Anschlusselektronik 20 dienende vierte Leiterplatte 15.4, die quer zu der Längsachse 70 des Feldgerätegehäuses ausgerichtet und somit im Wesentlichen parallel zu der zweiten Leiterplatte 15.2 orientiert ist. Die Feldgerätelektronik ist im dargestellten Ausführungsbeispiel derartig ausgebildet, dass die zu der Längsachse quer angeordnete zweite Leiterplatte 15.2 und die ebenfalls zu der Längsachse quer angeordnete vierte Leiterplatte 15.4 die beiden anderen Leiterplatten 15.1 und 15.3, die entlang der Längsachse angeordnet sind, nach oben und unten hin begrenzen bzw. einschließen. Die als Anschlusselektronik 20 dienende vierte Leiterplatte 15.4 umfasst einen Feldkontaktstecker 21, der in einer Längsachse der Leiterplatte 25 an einer Leiterplattenkante angeordnet und an dieser angelötet ist. Durch den Feldkontaktstecker 21 können Daten, insbesondere Messwerte von dem Feldgerät 10 zu einer externen Einheit, bspw. einer übergeordneten Einheit oder einem anderen Feldgerät, übertragen werden.

Ergänzend oder alternativ kann auch die Energieversorgung für das Feldgerät über den Feldkontaktstecker realisiert sein. Bei dem Feldkontaktstecker 21 kann es sich insbesondere um einen Rundsteckverbinder, bspw. einen M12-Rundsteckverbinder handeln. Um den Feldkontaktstecker nach außen zu führen, weist das Feldgerätegehäuse 12 eine entsprechend ausgebildet Gehäuseöffnung 18 auf. Die vierte Leiterplatte 25 kann ebenfalls über eine zweite Steck- und Gegensteckverbindung 15.6 mit der ersten Leiterplatte 15.1 elektrisch verbunden sein. Ferner können auf der vierten Leiterplatte 15.4 elektronische Komponenten für EMV- und/oder Explosionsschutz-Maßnahmen 24 aufgebracht sein.

An einem oberen Ende des Feldgerätes 10 weist das Feldgerätegehäuse 12 ein Display zur Anzeige und/oder Bedienung 19 auf. Das Display 19 kann zur Bedienung kapazitive Tasten aufweisen. Diese können bspw. durch eine entsprechende kapazitive Folie realisiert sein. Um den hygienischen Anforderungen gerecht zu werden, kann das Display hinter einer in dem Gehäuse 12 integrierten Sicht- bzw. Bedienscheibe 11 im Innenraum 13 des Feldgerätes angeordnet sein. Um eine möglichst gute Darstellung bzw. Ablesbarkeit der Information auf dem hinter der Sichtscheibe 11 platzierten Display 19 zu haben und/oder eine reibungsfreie Bedienung von kapazitiven Tasten zu haben, sollte das Display 19 möglichst plan und/oder gleichmäßig an der Rückseite der Sicht- bzw. Bedienscheibe 11 anliegen. Hierzu kann beispielsweise ein Displayrahmen 30, der das Display einerseits aufnimmt und andererseits entsprechend hinter der Sicht- bzw. Bedienscheibe 11 platziert, dienen.

Die Leiterplatten 15.1 bis 15.4 der Feldgeräteelektronik 15 können zumindest teilweise in einem Leierplattenhalter 16 angeordnet sein, so dass sie durch diesen mechanisch fixiert werden können. Der Leiterplattenhalter 16 ist mit seiner Außenkontur derartig ausgeführt, dass er zumindest abschnittsweise im Wesentlichen bündig an einer Innenwandung des rotationssymmetrischen Bereichs anliegt.

In dem dargestellten Ausführungsbeispiel weist der Leiterplattenhalter 16 eine becherähnliche Form auf. Zur Aufnahme der Leiterplatten kann der Leiterplattenhalter 16 an einer Innenseite seitliche Führungsschienen aufweisen, durch die die entlang der Längsachse des Feldgerätegehäuses orientierten/angeordneten Leiterplatten geführt werden. Hierbei können zwei, vorzugsweise diametral zueinander angeordnete Führungsschienen zur Aufnahme einer Leiterplatte vorgesehen sein. Durch den Leiterplattenhalter wird in dem in Fig. 1 dargestellten Ausführungsbeispiel die als Anschlusselektronik dienende vierte Leiterplatte 15.4 mechanisch fixiert.

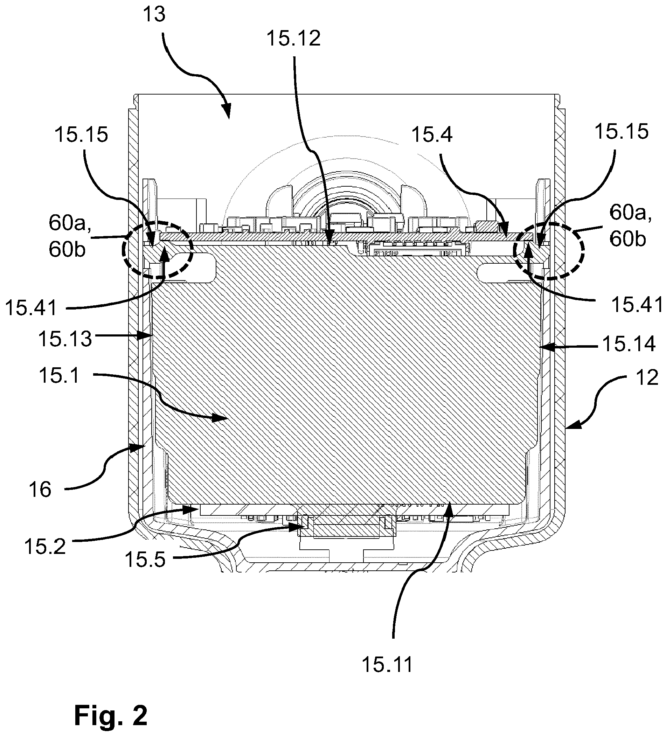

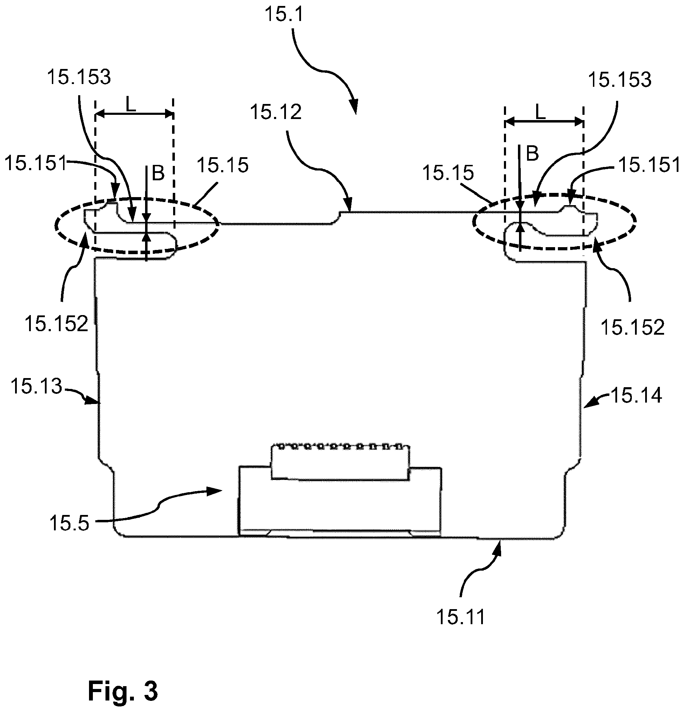

Erfindungsgemäß ist die erste Leiterplatte 15.1 derartig ausgebildet, dass diese an der der ersten Leiterplattenkante 15.11 gegenüberliegenden zweiten Leiterplattenkante 15.12 eine derartige Außenkontur aufweist, dass die erste Leiterplatte 15.1 seitlich zwei federarmähnliche Segmente 15.15 aufweist. Die federarmähnlichen Segmente 15.15 können bspw. durch entsprechendes Fräsen der Außenkontur der Leiterplatte erzeugt werden. Fig. 2 zeigt eine solche in den Leiterplattenhalter 16 eingebracht Leiterplatte 15.1 mit entsprechend ausgebildeten federarmähnlichen Segmenten 15.15 und Fig. 3 die freigestellte Leiterplatte 15.1. Die federarmähnlichen Segmente sind derartig ausgebildet, dass diese jeweils einen länglichen Steg 15.153 aufweisen. Der längliche Steg 15.153 kann dabei derartig ausgeführt sein, dass dieser eine Breite B im Bereich von 1,5 - 0,5 mm, vorzugsweise im Bereich von 0,8 - 1,2 mm bei einer Leiterplattendicke von ca. 1 mm aufweist. Ferner kann der längliche Steg eine Länge im Bereich von 5 - 20 mm aufweisen.

Ergänzend können, wie aus Fig. 3 ersichtlich, die federarmähnlichen Segmente 15.15 an der zweiten Leiterplattenkante 15.12 der ersten Leiterplatte 15.1 jeweils zumindest eine hervorstehende Anschlagsfläche 15.151 zum Abstützen an Widerlagern 15.41 der vierten Leiterplatte 15.4 aufweisen. Als Widerlage 15.41 kann bspw. eine Rückseite der in dem Feldgerätegehäuse 12 mechanisch fixierten vierten Leiterplatte 15.4 dienen. Vorteilhafterweise ist die vierte Leiterplatte 15.4 durch den Leiterplattenhalter 16 in dem Feldgerätegehäuse 12 mechanisch fixiert. Alternativ kann sie aber auch auf andere Art und Weise ohne den Leiterplattenhalter in dem Feldgerätegehäuse 12 mechanisch fixiert sein.

Ergänzend kann der Leiterplattenhalter 16 einen Einrastmechanismus 60a zur widerstandsfähigen Befestigung der ersten Leiterplatte 15.1 umfassen. Die erste Leiterplatte 15a selbst umfasst hierfür wiederum einen entsprechenden Gegeneinrastmechanismus 60b. Vorzugsweise sind die federarmähnlichen Segmente 15.15 derartig ausgebildet, dass sie den Gegeneinrastmechanismus 60b aufweisen. Dies kann bspw. durch seitliche an den federarmähnlichen Segmenten 15.15 angebrachte Rastnasen 15.152 realisiert sein. Der Einrast- bzw. Gegeneinrastmechanismus 60a, 60b ist im oberen Bereich des Leiterplattenhalters, d.h. an der vom Sensor- und/oder Aktorelement 14 abgewandten Seite des Leiterplattenhalters 16, angeordnet. Durch einen entsprechend ausgebildeten Einrast- und Gegeneinrastmechanismus 60a, 60b ist es bei der Herstellung der Feldgeräteelektronik möglich, dass ein Verrutschen, insb. ein Herausrutschen, der ersten Leiterplatte aus dem Leiterplattenhalter 16 in der Situation verhindert wird, wo die vierte Leiterplatte 15.4 noch nicht in den Innenraum 13 des Feldgerätegehäuses 12 eingebracht ist. Der Einrast- und Gegeneinrastmechanismus 60a, 60b ist ferner so ausgebildet, dass trotz des ineinander Rastens eine axiale Bewegung der ersten Leiterplatte möglich ist, so dass, die erste Steck- und Gegensteckverbindung 15.5 durch die erzeugte Spannung entlang der Längsachse 70 des Feldgerätegehäuses ineinander gepresst wird.

Alternativ zu der Abstützung an den Widerlagen der vierten Leiterplatte 15.4 kann auch der Leiterplattenhalter 16 entsprechend ausgebildete Widerlager aufweisen, durch die die federarmähnlichen Segmente 15.15 der vierten Leiterplatte 15.4 abgestützt werden. Insbesondere können die Widerlager in Form von Ausnehmungen, vorzugsweise in Form von Öffnungen, die in die Wandung des Leiterplattenhalters eingebracht sind, ausgebildet sein.

Durch die federarmähnlichen Segmente 15.15 der ersten Leiterplatte 15.1 ist es somit möglich, dass die erste Leiterplatte 15.1 im in das Feldgerätegehäuse 12 eingebrachten bzw. im eingebauten Zustand eine Spannung entlang der Längsachse 70 des Feldgerätegehäuses 12 erzeugt wird, so dass die an der ersten Leiterplattenkante 15.11 angeordnete erste Steck- und Gegensteckverbindung 15.5 ineinander gepresst wird, um bspw. Fertigungsbedingte Toleranzen ausgleichen zu können.

Ferner kann der Leiterplattenhalter 16 bis zu einer vorbestimmten Vergusshöhe 27a mittels Vergussmasse 27 vergossen sein. Als Vergussmasse kann bspw. ein Silgel dienen. Für gewöhnlich ist die Vergusshöhe 27a derartig festgelegt, dass die Vergussmasse circa die Hälfte bis Zweidrittel des Volumens des Leiterplattenhalters 16 einnimmt. Gegebenenfalls kann die Vergussmasse aber auch deutlich mehr als die Hälfte bzw. Zweidrittel des Volumens des Leiterplattenhalters 16 einnehmen. Der Einrast- und Gegeneinrastmechanismus 60a, 60b ist dann in dem Bereich des Leiterplattenhalters 16 bzw. der Leiterplatte 15a angeordnet, der nicht vergossen ist. In Kombination mit der Vergussmasse verhindert der Einrast- und Gegeneinrastmechanismus ein Aufschwimmen der Leiterplatte in dem Vergussbecher, solange die Vergussmasse noch nicht ausgehärtet ist.

### Bezugszeichenliste

- 10: Feldgerät der Automatisierungstechnik
- 11: Sichtscheibe
- 12: Feldgerätegehäuse
- 13: Innenraum
- 14: Sensor- und/oder Aktorelement
- 15: Feldgeräteelektronik
- 15.1: Erste Leiterplatte
- 15.11: Erste Leiterplattenkante der ersten Leiterplatte
- 15.12: Zweite Leiterplattenkante der ersten Leiterplatte
- 15.13: Dritte bzw. seitliche Leiterplattenkante der ersten Leiterplatte
- 15.14: Vierte bzw. seitliche Leiterplattenkante der ersten Leiterplatte
- 15.15: Federarmähnliche Segmente
- 15.151: Hervorstehende Anschlagsflächen
- 15.152: Rastnase
- 15.153: Länglicher Steg
- 15.2: Zweite Leiterplatte
- 15.3: Dritte Leiterplatte
- 15.4: Als Anschlusselektronik dienende weitere Leiterplatte
- 15.41: Widerlager der weiteren Leiterplatte
- 15.5: Erste Steck- und Gegensteckverbindung
- 15.6: Zweite Steck- und Gegensteckverbindung
- 15.7: Dritte Steck- und Gegensteckverbindung
- 16: Leiterplattenhalter
- 17: Rotationssymmetrischer Teilbereich
- 18: Gehäuseöffnung
- 19: Display
- 20: Anschlusselektronik
- 21: Feldkontaktstecker
- 24: Elektronische Bauteile, bspw. für EMV- und/oder Ex-Schutzmaßnahmen
- 26: Steckerhülse für Feldkontaktstecker
- 27: Vergussmasse
- 27a: Vorbestimmte Vergusshöhe bis zu der die Leiterplatte im Leiterplattenhalter mit der Vergussmasse vergossen ist
- 28: Prozessanschluss
- 30: Displayrahmen
- 40: Displayhalter
- 50: Trägerplatte bzw. Leiterplatte
- B: Detailansicht des Einrast- und Gegeneinrastmechanismus
- 60a: Einrastmechanismus des Leiterplattenhalters, insb. Ausnehmung
- 60b: Gegeneinrastmechanismus der ersten Leiterplatte
- 70: Längsachse des Feldgerätes
- B: Breite des federarmähnlichen Segmentes
- L: Länge des federarmähnlichen Segmentes

## Patentansprüche

1. Feldgerät der Automatisierungstechnik (10), aufweisend:
- ein Feldgerätegehäuse (12);
- eine in dem Feldgerätegehäuse angeordnete Feldgeräteelektronik (15) mit zumindest einer ersten Leiterplatte (15.1), die vorzugsweise entlang einer Längsachse (70) des Feldgerätegehäuse (12) ausgerichtet bzw. orientiert ist und einer zweiten Leiterplatten (15.2), die vorzugsweise quer zu einer Längsachse (70) des Feldgerätegehäuses (12) ausgerichtet bzw. orientiert ist, wobei die erste und die zweite Leiterplatte (15.1, 15.2) an einer ersten Leiterplattenkante (15.11) der zumindest ersten Leiterplatte (15.1) über eine erste Steck- und Gegensteckverbindung (15.5) elektrisch miteinander verbunden sind,
- wobei zumindest die erste Leiterplatte (15.1) an der der ersten Leiterplattenkante (15.11) gegenüberliegenden zweiten Leiterplattenkante (15.12) eine derartige Außenkontur aufweist, dass die erste Leiterplatte seitlich zwei federarmähnliche Segmente (15.15) aufweist, die durch entsprechende Ausformungen der Außenkontur an den zu einer Seitenwandung des Feldgerätegehäuses (12) gerichteten Leiterplattenkanten (15.13, 15.14) der ersten Leiterplatte ausgebildet sind, wobei die zumindest erste Leiterplatte (15.1) ferner derartig in das Feldgerätegehäuse (12) eingebracht ist, dass die federarmähnlichen Segmente (15.15) eine Spannung entlang der Längsachse (70) des Feldgerätegehäuses (12) erzeugen, so dass die an der ersten Leiterplattenkante (15.11) der zumindest ersten Leiterplatte (15.1) angeordnete erste Steck- und Gegensteckverbindung (15.5) ineinander gepresst wird.

2. Feldgerät der Automatisierungstechnik nach Anspruch 1, wobei die in dem Feldgerätegehäuse (12) angeordnete Feldgeräteelektronik (15) ferner eine weitere Leiterplatte (15.4) umfasst, die vorzugsweise quer zu der Längsachse (70) des Feldgerätegehäuses (12) ausgerichtet bzw. orientiert ist, wobei die weitere und die erste Leiterplatte (15.1, 15.4) an der zweiten Leiterplattenkante (15.12) der ersten Leiterplatte (15.1) über eine zweite Steck- und Gegensteckverbindung (15.6) elektrisch miteinander verbunden sind, wobei die weitere Leiterplatte (15.4) mechanisch in dem Feldgerätegehäuse (12) fixiert ist und wobei die weitere Leiterplatte (15.4) für die federarmähnlichen Segmente (15.15) der ersten Leiterplatte entsprechende Widerlager (15.41) aufweist, wobei die Widerlage (15.41) und die erste sowie die weitere Leiterplatte (15.1, 15.4) derartig zueinander angeordnet und/oder ausgebildet sind, dass im eingesteckten Zustand der zweiten Steck- und Gegensteckverbindung (15.6) die federarmähnlichen Segmente (15.15) der ersten Leiterplatte (15.1) durch die Widerlager (15.41) der weiteren Leiterplatte (15.4) derartig abgestützt werden, dass die Spannung entlang der Längsachse (70) des Feldgerätegehäuses (12) erzeugt und somit die an der ersten Leiterplattenkante (15.11) der zumindest ersten Leiterplatte (15.1) angeordnete erste Steck- und Gegensteckverbindung (15.5) ineinander gepresst wird.

3. Feldgerät der Automatisierungstechnik nach dem vorhergehenden Anspruch, wobei die federarmähnlichen Segmente (15.15) an der zweiten Leiterplattenkante (15.12) der ersten Leiterplatte (15.1) jeweils zumindest eine hervorstehende Anschlagsfläche (15.151) zum Abstützen an den Widerlagern (15.41) der weiteren Leiterplatte (15.4) aufweisen und/oder als Widerlager (15.41) Teile einer Unterseite der weiteren Leiterplatte (15.4) dienen.

4. Feldgerät der Automatisierungstechnik nach einem der vorhergehenden Ansprüche, ferner umfassend einen in dem Feldgerätegehäuse (12) angeordneten Leiterplattenhalter (16) zur Halterung zumindest der weiteren Leiterplatte (15.4), wobei die weitere Leiterplatte (15.4) durch den Leiterplattenhalter (16) mechanisch in dem Feldgerätegehäuse (12) fixiert ist, wobei der Leiterplattenhalter (16) mit einer umlaufenden Außenkontur einer Wandung zumindest in einem Teilabschnitt (17) an eine Innenkontur des Feldgerätegehäuses (12) derartig angepasst ist, dass die Außenkontur des Leiterplattenhalters (16) an der Innenkontur des Feldgerätegehäuses (12) im Wesentlichen bündig anliegt, wobei der Leiterplattenhalter (16) im Bereich des Teilabschnittes (17) zumindest einen Einrastmechanismus (60a) zur Befestigung der ersten Leiterplatte (15.1) und die erste Leiterplatte (15.1), insb. die federarmähnlichen Segmente der ersten Leiterplatte (15.1), zumindest einen zu dem Einrastmechanismus des Leiterplattenhalters (60a) entsprechenden Gegeneinrastmechanismus (60b) aufweisen, wobei der Einrast- und Gegeneinrastmechanismus (60a, 60b) so aufeinander abgestimmt und ausgebildet ist, dass im eingerasteten Zustand ein Verrutschen, insb. ein Herausrutschen, der ersten Leiterplatte (15.1) aus dem Leiterplattenhalter (16) verhindert wird aber dennoch im eingerasteten Zustand eine axiale Bewegung der ersten Leiterplatte (15.1) möglich ist, so dass, durch die erzeugte Spannung entlang der Längsachse (70) des Feldgerätegehäuses, die erste Steck- und Gegensteckverbindung (15.5) ineinander gepresst wird.

5. Feldgerät der Automatisierungstechnik nach Anspruch 1, ferner umfassend einen in dem Feldgerätegehäuse (12) angeordneten Leiterplattenhalter (16) zur Halterung zumindest der ersten und/oder der zweiten Leiterplatte (15.1, 15.2), wobei der Leiterplattenhalter (16) mit einer umlaufenden Außenkontur einer Wandung zumindest in einem Teilabschnitt (17) an eine Innenkontur des Feldgerätegehäuses (12) derartig angepasst ist, dass die Außenkontur des Leiterplattenhalters (16) an der Innenkontur des Feldgerätegehäuses (12) im Wesentlichen bündig anliegt, wobei der Leiterplattenhalter (16) für die federarmähnlichen Segmente (15.15) der ersten Leiterplatte (15.1) entsprechende Widerlager umfasst, die derartig angeordnet und ausgebildet sind, dass die federarmähnlichen Segmente (15.15) der ersten Leiterplatte (15.1) in einem eingeführten Zustand, bei dem die erste Leiterplatte (15.1) in den Leiterplattenhalter (16) eingeführt ist, durch die Widerlager derartig abgestützt werden, dass die Spannung entlang der Längsachse des Feldgerätegehäuses (12) erzeugt und somit die an der ersten Leiterplattenkante (15.11) der zumindest ersten Leiterplatte (15.1) angeordnete erste Steck- und Gegensteckverbindung (15.5) ineinander gepresst wird.

6. Feldgerät der Automatisierungstechnik nach dem vorhergehenden Anspruch, wobei die Widerlager in Form von Ausnehmungen, insb. Öffnungen, die in die Wandung des Leiterplattenhalters (16) eingebracht sind, ausgeführt sind.

7. Feldgerät nach einem oder mehreren der vorhergehenden Ansprüche, wobei der Leiterplattenhalter (16) eine becherähnliche Form aufweist.

8. Feldgerät nach einem oder mehreren der vorhergehenden Ansprüche, wobei die federarmähnlichen Segmente (15.15) jeweils einen länglichen Steg aufweisen, der vorzugsweise eine Länge im Bereich von 5 - 20 mm und/oder vorzugsweise eine Breite im Bereich von 1,5 - 0,5 mm, vorzugsweise im Bereich von 0,8 - 1,2 mm aufweist.
